# EUROPEAN PATENT APPLICATION

(11) **EP 2 592 656 A1**
(43) Date of publication of application: **15.05.2013**
(21) Application number: 11803312.5
(22) Date of filing: 04.07.2011
(51) Int. Cl.: H01L 31/04

(54) **PHOTOELECTRIC CONVERSION ELEMENT AND SOLAR CELL COMPRISING SAME**

(30) Priority: 06.07.2010 JP 2010153648
(71) Applicant: FUJIFILM Corporation, Tokyo 106-8620 (JP)
(72) Inventor: KAWANO, Tetsuo, Ashigarakami-gun Kanagawa 258-8577 (JP); YAMAMOTO, Mayu, Ashigarakami-gun Kanagawa 258-8577 (JP)
(74) Representative: HOFFMANN EITLE
(86) International application number: PCT/JP2011/003814
(87) International publication number: WO 2012/004974

(57) **Abstract**

[Problems to be Solved]

To provide a photoelectric conversion device that includes a buffer layer capable of uniformly covering an underlayer and has high in-plane homogeneity of photoelectric conversion efficiency.

[Means for Solving the Problems]

The photoelectric conversion device of the present invention is a photoelectric conversion device 1 which includes a substrate (10) on which the following are layered in the order listed below: a lower electrode layer (20); a photoelectric conversion semiconductor layer (30) which includes, as a major component, at least one kind of compound semiconductor having a chalcopyrite structure formed of a group Ib element, a group IIIb element, and a group VIb element; a buffer layer (40); and a transparent conductive layer (50), in which the buffer layer (40) includes a ternary compound of a cadmium-free metal, oxygen, and sulfur, and has a carbonyl ion (C) on a surface (40s) facing the transparent conductive layer (50) .

## Description

### Technical Field

The present invention relates to a photoelectric conversion device and a solar cell having the same.

### Background Art

Photoelectric conversion devices having a photoelectric conversion layer and electrodes in electrical communication with the layer are used in various applications including solar cells. Most of the conventional solar cells are Si-based cells that use bulk monocrystalline Si, polycrystalline Si, or thin film amorphous Si. Recently, however, research and development of compound semiconductor-based solar cells that do not depend on Si has been carried out. Two types of compound semiconductor-based solar cells are known, one of which is a bulk system, such as GaAs system and the like, and the other of which is a thin film system, such as CIS system formed of a group Ib element, a group IIIb element, and a group VIb element, CIGS, or the like. GI(G)S is a compound semiconductor represented by a general chemical formula, Cu_{1-z}In₁₋ₓGaₓSe_{2-y}S_{y} (where, 0≤x≤1, 0≤y≤2, and 0≤z≤1), and the formula represents a CIS system when x=0 and a CIGS system when x>0. The CIS and CIGS are herein collectively represented as "CI(G)S".

In conventional thin film photoelectric conversion devices such as CI(G)S systems and the like, a CdS buffer layer is usually provided between a photoelectric conversion layer and a transparent conductive layer (transparent electrode) . In such system, the buffer layer is formed by CBD (Chemical Bath Deposition) process.

Rolls of the buffer layer may include (1) prevention of recombination of photogenerated carriers (2) band discontinuity alignment (3) lattice matching and (4) coverage of surface unevenness of the photoelectric conversion layer. It is considered that the CBD process, which is a liquid phase deposition process, is preferable for CI (G) S systems in order to satisfy, in particular, (4) above, as the surface unevenness of the photoelectric conversion layer is relatively large.

In view of the environmental burden, Cd-free buffer layers are under study, and as a major component of Cd-free buffer layers, use of zinc systems, such as ZnO systems, ZnS systems, and the like is also under consideration.

Japanese Unexamined Patent Publication No. 2000-332280 (Patent Document 1) discloses a method of producing a Zn(O, OH, S) buffer layer using a reaction solution that includes a zinc-containing compound, a sulfur-containing compound, and an ammonium salt (Claim 1). Patent Document 1 also describes that a reaction solution that includes 0.5 mol/l or less of ammonia is preferably used (Claim 2) . Patent Document 1 further describes that a reaction temperature of 10 to 100°C and a pH of 9.0 to 11.0 are preferable (Claims 6 and 7).

Japanese Unexamined Patent Publication No. 2001-196611 (Patent Document 2) discloses a method of producing a Zn(S, O) buffer layer using a reaction solution containing zinc acetate, thiourea, and ammonia (Example 3). In Example 3 of Patent Document 2, concentrations of the zinc acetate, thiourea, and ammonia are 0.025M, 0.375M, and 2.5M respectively.

Japanese Unexamined Patent Publication No. 2002-343987 (Patent Document 3) discloses a method of producing a Zn(S, O, OH) buffer layer using a reaction solution which is a mixture of a solution provided by dissolving zinc salt in ammonia water or ammonium hydroxide water and an aqueous solution provided by dissolving sulfur-containing salt in purified water (Claim 1) . Patent Document 3 describes that the film forming is performed with a transparency level of the reaction solution of 100% to 50% (Claim 1). Patent Document 3 further describes that a reaction temperature of 80 to 90°C and a pH of 10.0 to 13.0 are preferable (Claims 5 and 6).

Japanese Unexamined Patent Publication No. 2003-124487 (Patent Document 4) discloses a method of producing a Zn(S, O) buffer layer by a roll-to-roll process using a reaction solution containing zinc acetate, thiourea, and ammonia (Claim 2 and Example 2). In Example 2 of Patent Document 4, concentrations of the zinc acetate, thiourea, and ammonia are 0.025M, 0.375M, and 2.5M respectively.

Japanese Unexamined Patent Publication No. 2002-118068 (Patent Document 5) discloses a method of producing a ZnS buffer layer using a reaction solution containing zinc sulfate, ammonia, and thiourea (Claim 4). PCT Japanese Publication No. 2008-510310 (Patent Document 6) discloses a method of producing a buffer layer which includes the steps of dissolving a 0.05 to 0.5 mol/l of zinc sulfate and a 0.2 to 1.5 mol/l of thiourea in distilled water at a temperature of 70 to 90°C, adding about 25% ammonia in the amount of 1/3 of the water, and after the solution becomes transparent, dipping the substrate in the solution for about 10 minutes to maintain the temperature substantially at constant during the time (Claim 1).

A literature (Non-Patent Document 1), D. Johnston et al., "Chemical bath deposition of zinc sulphide thin films using sodium citrate as a complementary complexing agent", Journal of Materials Science Letters, Vol. 20, No. 10, pp. 921-923, 2001 and a literature (Non-Patent Document 2), D.A. Johnston et al., "Chemical bath deposition of zinc sulfide based buffer layers using low toxicity material". Thin Solid Films, Vols. 403-404, pp. 102-106, 2002 describe a method of producing a ZnS thin film using a reaction solution containing zinc sulfate, thiourea, ammonia, and sodium citrate. In Non-patent Documents 1 and 2, the film forming is performed at a reaction temperature of 60 to 80°C.

A literature (Non-Patent Document 3), H.J. Lee and S.I. Lee, "Deposition and optical properties of nanocrystalline ZnS thin films by a chemical method", Current Applied Physics, Vol. 7, Issue 2, pp. 193-197, 2007 describes a method of producing a ZnS thin film using a reaction solution containing zinc sulfate and thioacetamide. In Non-patent Document 3, the film forming is performed at a reaction temperature of 95°C with a reaction time of 90 to 120 minutes.

### Disclosure of Invention

As described above, it is difficult to form a buffer layer on a CI(G)S photoelectric conversion semiconductor layer having relatively large surface unevenness as a uniform film without any gap. A defect in the buffer layer, such as a gap or crack, may cause problems, such as degradation in the photoelectric conversion efficiency due to loss of buffering effects in the defective portion, a variation in the photoelectric conversion efficiency from cell to cell due to degraded in-plane homogeneity of photoelectric conversion efficiency, and the like. Further, in view of the production efficiency and cost, a high reaction speed is preferable in the film forming process for the buffer layer by CBD method.

Japanese Unexamined Patent Publication No. 2007-242646 (Patent Document 7) discloses a method of forming a buffer layer by providing a nucleus, which is a particle of the same kind as or a different kind from that of the buffer layer, and forming the buffer layer with the nucleus as the starting point or the catalyst (Claim 1). Further, ZnS is specifically cited as a major component of the particle serving as the nucleus and the buffer layer (Claim 8).

Patent Document 7 discloses that by growing a CBD film after forming a fine particle layer that functions as the nucleus of crystal growth, catalyst, or the like, the reaction speed of the CBD film forming process may be increased and a highly homogeneous buffer layer with comparatively less fine particle masses or cracks having gaps may be formed by controlling the crystal growth with the fine particle layer.

Patent Document 7, however, describes nothing about evaluation results of film surface homogeneity for the obtained buffer layers, photoelectric conversion efficiency that supports the homogeneity of the buffer layer, and uniformity, so that it is unclear that the advantageous effects described above may actually be obtained. Further, as the reaction solution of Patent Document 7 is highly alkaline, substrates containing metals which are easily dissolved in an alkaline solvent, such as metals, including aluminum, capable of forming a complex ion with a hydroxide ion, cannot be used.

The present invention has been developed in view of the circumstances described above, and it is an object of the present invention to provide a photoelectric conversion device that includes a buffer layer capable of uniformly covering an underlayer and has high in-plane homogeneity of photoelectric conversion efficiency.

It is a further object of the present invention to provide a photoelectric conversion device that includes a Zn buffer layer which can be formed on a substrate that includes a metal easily dissolved in an alkaline solvent and has high in-plane homogeneity of photoelectric conversion efficiency.

A photoelectric conversion device of the present invention is a device, including a substrate on which the following are layered in the order listed below: a lower electrode layer; a photoelectric conversion semiconductor layer which includes, as a major component, at least one kind of compound semiconductor having a chalcopyrite structure formed of a group Ib element, a group IIIB element, and a group VIb element; a buffer layer; and a transparent conductive layer, in which the buffer layer includes a ternary compound of a cadmium-free metal, oxygen, and sulfur, and has a carbonyl ion on a surface facing the transparent conductive layer. Preferably, the carbonyl ion is adsorbed on the surface.

The term "major component" as used herein refers to a component with a content of 80% by mass or more, unless otherwise specifically described.

In the photoelectric conversion device of the present invention, it is preferable that the carbonyl ion has a plurality of carbonyl groups and it is more preferable that the carbonyl ion is a citrate ion.

Preferably, the buffer layer includes a crystalline portion and an amorphous portion, and a molar ratio of sulfur atoms to a total number of moles of the sulfur atoms and oxygen atoms in the buffer layer is in the range from 0.2 to 0.8.

The cadmium-free metal is preferable to be at least one kind of metal (which may include an unavoidable impurity) selected from the group consisting of Zn, In, and Sn and is more preferable to be Zn.

Preferably, the photoelectric conversion device of the present invention includes, in the substrate, a metal capable of forming a complex ion with a hydroxide ion. As for such substrate, an anodized substrate selected from the group consisting of the following is preferably used:
an anodized substrate formed of an Al-based Al base with an Al₂O₃-based anodized film formed on at least one surface side;
an anodized substrate formed of a composite base of a Fe-based Fe material and an Al-based Al material attached to at least one surface side of the Fe material with an Al₂O₃-based anodized film formed on at least one surface side of the composite base; and
an anodized substrate formed of a base of a Fe-based Fe material and an Al-based Al film formed on at least one surface side of the Fe material with an Al₂O₃-based anodized film formed on at least one surface side of the base.

A solar cell of the present invention is a solar cell, including the photoelectric conversion device of the present invention described above.

The buffer layer of the photoelectric conversion device of the present invention includes a ternary compound of a cadmium-free metal, oxygen, and sulfur, and has a carbonyl ion on a surface facing the transparent conductive layer. According to such arrangement, the compactness of the buffer layer is increased by the presence of the carbonyl ion. Thus, according to the present invention, a photoelectric conversion device that includes a buffer layer uniformly covering an underlayer and has high in-plane homogeneity of photoelectric conversion efficiency may be provided.

Further, such buffer layer may be formed under moderate alkaline conditions, so that a base material which includes a metal easily soluble in an alkaline solvent, such as aluminum, may be used as the substrate. Therefore, an embodiment having a substrate that includes a thin and highly flexible aluminum metal may provide a flexible photoelectric conversion device having high in-plane homogeneity of photoelectric conversion efficiency.

### Brief Description of Drawings

Figure 1 is a schematic cross-sectional view of a photoelectric conversion device according to an embodiment of the present invention.
Figure 2 is a schematic cross-sectional view of an anodized substrate, illustrating the structure thereof.
Figure 3 is a perspective view illustrating a method of manufacturing an anodized substrate.
Figure 4 illustrates IR spectra of buffer layer surfaces of Examples 1 and 2, CIGS surface, and various kinds of raw powders.
Figure 5 illustrates composition analysis results in a depth direction of Sample 1 in Example 1.
Figure 6 illustrates composition analysis results in a depth direction of Sample 2 in Example 2.
Figure 7 is a schematic cross-sectional view of the samples evaluated in Figures 5 and 6.

### Best Mode for Carrying Out the Invention

### [Photoelectric Conversion Device]

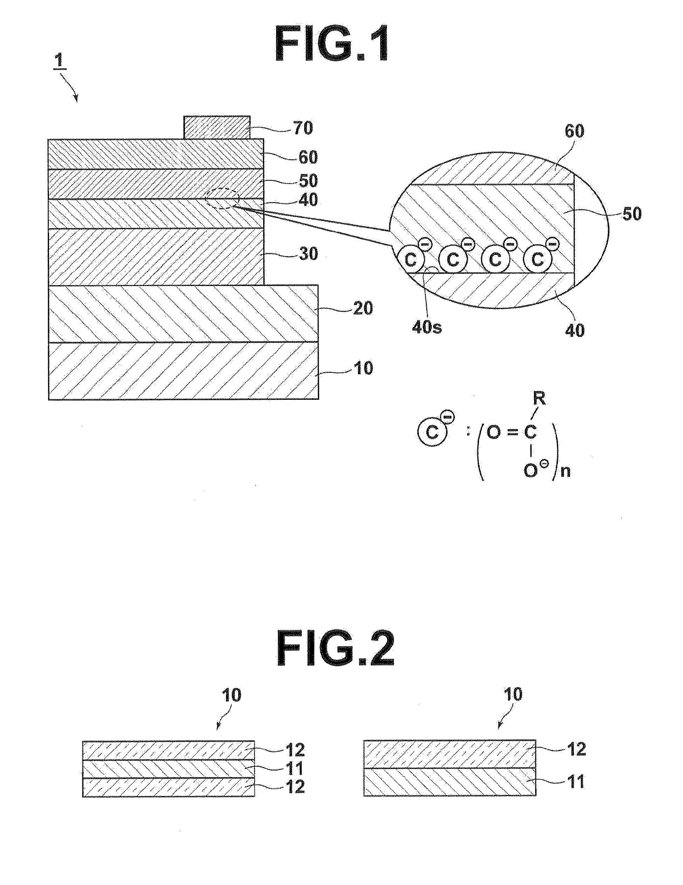

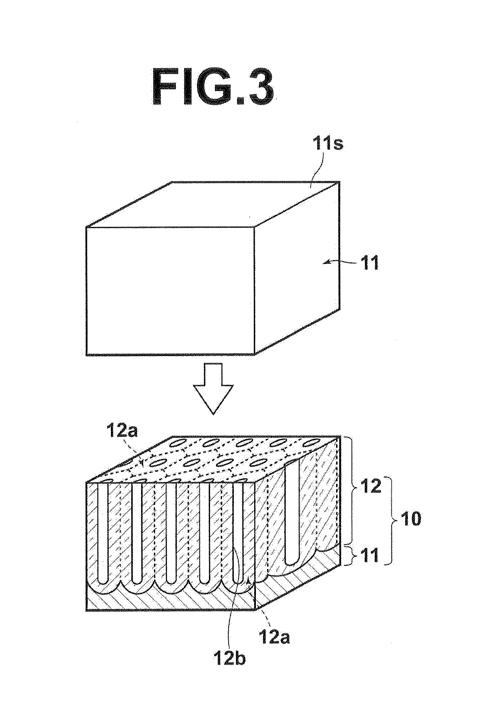

A structure of a photoelectric conversion device according to an embodiment of the present invention will now be described with reference to the accompanying drawings. Figure 1 is a schematic cross-sectional view of the photoelectric conversion device, Figure 2 schematically illustrates cross-sectional views of two substrates, illustrating the structures thereof, and Figure 3 is a perspective view illustrating a method of manufacturing an anodized substrate. In the drawings, each element is not necessarily drawn to scale for ease of visual recognition.

The photoelectric conversion device 1 is a device having substrate 10 on which the following are layered in the order listed below: a lower electrode (back contact electrode) 20; a photoelectric conversion semiconductor layer 30 which includes, as a major component, at least one kind of compound semiconductor having a chalcopyrite structure formed of a group Ib element, a group IIIb element, and a group VIb element; a buffer layer 40; a window layer 50; a transparent conductive layer (transparent electrode) 60; and an upper electrode (grid electrode) 70. The photoelectric conversion device 1 is characterized by the fact that the buffer layer 40 includes a ternary compound of a cadmium-free metal, oxygen, and sulfur, and has a carbonyl ion on a surface 40s of the buffer layer 40 facing the transparent conductive layer 60. Figure 1 also shows an enlarged surface 40s and schematically illustrates that carbonyl ions are present on the surface 40s. A carbonyl ion is represented by an abbreviated form of C⁻ in the drawing. The window layer 50 may sometimes be omitted. Each component of the photoelectric conversion device 1 will be described hereinafter.

### (Substrate)

As for the substrate 10, as for the substrate, there is not any specific restriction and the following may be cited by way of example: a glass substrate; a metal substrate, such as stainless steel substrate, on which an insulating layer is formed; an anodized substrate formed of an Al-based Al base with an Al₂O₃-based anodized film formed on at least one surface side; an anodized substrate formed of a composite base of a Fe-based Fe material and an Al-based Al material attached to at least one surface side of the Fe material with an Al₂O₃-based anodized film formed on at least one surface side of the composite base; an anodized substrate formed of a base of a Fe-based Fe member and an Al-based Al film formed on at least one surface side of the Fe material with an Al₂O₃-based anodized film formed on at least one surface side of the base; and a resin substrate, such as polyimide substrate.

Flexible substrates, such as a metal substrate on which an insulating film is formed, an anodized substrate, a resin substrate, and like, are preferably used as they can be manufactured by a roll-to-roll process (continuous process).

In view of the thermal expansion coefficient, heat resistance, and insulating property of the substrate, an anodized substrate selected from the group consisting of the following is particularly preferable: an anodized substrate formed of an Al-based Al base with an Al₂O₃-based anodized film formed on at least one surface side; an anodized substrate formed of a composite base of a Fe-based Fe material and an Al-based Al material attached to at least one surface side of the Fe material with an Al₂O₃-based anodized film formed on at least one surface side of the composite base; and an anodized substrate formed of a base of a Fe-based Fe material and an Al-based Al film formed on at least one surface side of the Fe material with an Al₂O₃-based anodized film formed on at least one surface side of the base.

Figure 2 schematically illustrates a substrate having an Al base 11 with an anodized film 12 formed on each side of the Al base 11 on the left and a substrate having an Al base 11 with an anodized film 12 formed on either one of the sides on the right. Anodized film 12 is an Al₂O₃-based film.

Preferably, substrate 10 is a substrate having an Al base 11 with an anodized film 12 formed on each side, as illustrated on the left in Figure 2 in order to prevent warpage of the substrate due to the difference in thermal expansion coefficient between Al and Al₂O₃ and detachment of the film due to the warpage during the device manufacturing process.

Anodization may be performed by dipping Al base 11, which is cleaned, smoothed by polishing, and the like, as required, as an anode together with a cathode in an electrolyte, and applying a voltage between the anode and cathode. As for the cathode, carbon, aluminum, or the like is used. There is not any specific restriction on the electrolyte and an acid electrolyte that includes one kind or two or more kinds of acids, such as sulfuric acid, phosphoric acid, chromic acid, oxalic acid, sulfamic acid, benzenesulfonic acid, amido-sulfonic acid, and the like, is preferably used.

There is not any specific restriction on the anodizing conditions, which are dependent on the electrolyte used. As for the anodizing conditions, for example, the following are appropriate: an electrolyte concentration of 1 to 80% by mass; a solution temperature of 5 to 70°C; a current density of 0.005 to 0.60 A/cm²; a voltage of 1 to 200V; and an electrolyzing time of 3 to 500 minutes.

As for the electrolyte, a sulfuric acid, a phosphoric acid, an oxalic acid, malonic acid, or a mixture thereof may preferably be used. When such electrolyte is used, the following conditions are preferable: an electrolyte concentration of 4 to 30% by mass, a solution temperature of 10 to 30°C, a current density of 0.05 to 0.30 A/cm², and a voltage of 30 to 150V.

As shown in Figure 3, when Al-based Al base 11 is anodized, an oxidization reaction proceeds from a surface 11s in a direction substantially perpendicular to surface 11s, and Al₂O₃-based anodized film 12 is formed. Anodized film 12 generated by the anodization process has a structure in which multiple fine columnar bodies, each having a substantially regular hexagonal shape in a plan view, are tightly arranged. Each fine columnar body 12a has a fine pore 12b, substantially in the center, extending substantially linearly in a depth direction from surface 11s, and the bottom surface of each fine columnar body 12a has a rounded shape. Normally, a barrier layer without any fine pore 12b is formed at a bottom area of fine columnar bodies 12a. Anodized film 12 without any fine pore 12b may be formed if appropriate anodization conditions are employed.

There is not any specific restriction on the thicknesses of the Al base 11 and anodized film 12. In view of the mechanical strength of the substrate 10 and trend toward thinness and lightness of the device, the thickness of the Al base 11 prior to anodization is preferable to be, for example, in the range from 0.05 to 0.6mm, and more preferably in the range from 0.1 to 0.3mm. In view of the insulating property, mechanical strength, and trend toward thinness and lightness, the thickness of the anodized film 12 is preferable to be, for example, in the range from 0.1 to 100µm.

### (Lower Electrode)

There is not any specific restriction on the major component of the lower electrode (back contact electrode) 20 and Mo, Cr, W, or a combination thereof is preferably used, in which Mo is particularly preferable. There is not any specific restriction on the thickness of the lower electrode (back contact electrode) 20 and a thickness in the range from 200 to 1000nm is preferable.

### (Photoelectric Conversion Layer)

There is not any specific restriction on the major component of photoelectric conversion layer 30. Since high photoelectric conversion efficiency can be obtained, at least one kind of compound semiconductor having a chalcopyrite structure is preferable, and a semiconductor formed of a group Ib element, a group IIIb element, and a group VIb element is more preferable as the major component of the photoelectric conversion layer 30.

As for the major component of the photoelectric conversion layer 30, at least one kind of compound semiconductor formed of at least one kind of group Ib element selected from the group consisting of Cu and Ag, at least one kind of group IIIb element selected from the group consisting of Al, Ga, and In, and at least one kind of group VIb element selected from the group consisting of S, Se, and Te is preferably used.

As for the compound semiconductors described above, the following may be included: CuAlS₂, CuGaS₂, CuInS₂, CuAlSe₂, CuGaSe₂, AgAlS₂, AgGaS₂, AgInS₂, AgAlSe₂, AgGaSe₂, AgInSe₂, AgAlTe₂, AgGaTe₂, AgInTe₂, Cu(In, Al)Se₂, Cu(In, Ga) (S, Se)₂, Cu_{1-z}In₁₋ₓGaₓSe_{2-y}S_{y} (where, 0≤x≤1, 0≤y≤2, 0≤z≤1), (CI (G) S), Ag(In, Ga)Se₂, Ag (In, Ga) (S, Se)₂, and the like. Further, Cu₂ZnSnS₄, Cu₂ZnSnSe₄, and Cu₂ZnSn(S, Se)₄ may also be included.

There is not any specific restriction on the film thickness of the photoelectric conversion semiconductor layer and a film thickness in the range from 1.0 to 4.0µm is preferable and more preferably in the range from 1.5 to 3.5µm.

### (Buffer Layer)

Buffer layer 40 is provided for (1) prevention of recombination of photogenerated carriers (2) band discontinuity alignment (3) lattice matching (4) coverage of surface unevenness of the photoelectric conversion layer, and the like. In the present embodiment, the buffer layer 40 includes a ternary compound of a cadmium-free metal, oxygen, and sulfur, and has a carbonyl ion on a surface 40s facing the transparent conductive layer 50.

There is not any specific restriction on the ternary compound of cadmium-free metal, oxygen, and sulfur, but a ternary compound of at least one kind of metal (which may include an unavoidable impurity) selected from the group consisting of Zn, In, and Sn, in addition to oxygen and sulfur, is preferable in view of the buffering function, and Zn (S, O) -based and/or Zn(S, O, OH) -based metal is more preferable. Here, the representation of Zn(S, O) and Zn(S, O, OH) refers respectively to a mixed crystal of zinc sulfide and zinc oxide, and a mixed crystal of zinc sulfide, zinc oxide, and zinc hydroxide. In this case, a part of the zinc sulfide, zinc oxide, or zinc hydroxide maybe present in an amorphous state without forming the mixed crystal. The term "major component" as used herein refers to a component with a content of 20% by mass or more. Further, the buffer layer 40 may be formed of only a Zn(S, O)-based and/or Zn(S, O, OH)-based Zn compound layer or a layered film of any other layer with a Zn(S, O)-based and/or Zn(S, O, OH)-based Zn compound layer.

In the present embodiment, carbonyl ions on the surface 40s may be present in any fashion as long as they are present on the surface but it is preferable that they are adsorbed on the surface 40s. In the case where the carbonyl ions are adsorbed on the surface 40s, there is not any specific restriction on the adsorption aspect. If the charge state of the surface 40s is positive, the carbonyl ions are adsorbed on the surface 40s by the interaction between the surface 40s and oxygen of the carbonyl ions. Such adsorption aspect is preferable, because in such adsorption aspect, the carbonyl ions are likely to be disposed densely on the surface 40s and, therefore, the surface of the photoelectric conversion semiconductor layer 30, the underlayer thereof, is likely to be uniformly covered, so that the compactness of the buffer layer 40 is increased. As for the carbonyl ion, there is not any specific restriction, but a carbonyl ion having a plurality of carbonyl groups is preferably used. This is considered to have been produced as a result that the growth of the buffer layer in the thickness direction is suppressed while the growth in the in-plane direction is promoted. An example of such carbonyl ion may be at least one kind of ion selected from a group consisting of citric acid ion, tartrate ion, and maleic acid ion. As being a trianion, the citric acid has three adsorbable sites, resulting in a dense and strong adsorption to the surface 40s. Consequently, a compact film can be expected so that the citric acid is preferably used.

Also, in the case where many Zn²⁺ ions are present on the surface 40s of the buffer layer, many adsorbable sites of carbonyl ions are present, so that the adsorption to the surface 40s is considered to become dense and strong, whereby a compact film is obtained.

Preferably, the buffer layer has a crystalline portion and an amorphous portion. Preferably, a molar ratio of sulfur atoms to a total number of moles of the sulfur atoms and oxygen atoms in the buffer layer is in the range from 0.2 to 0.8.

As described above, the buffer layer 40 has carbonyl ions on the surface 40s, and it is likely that carbonyl ions are also taken into the inside of the buffer layer 40 in the deposition process.

There is not any specific restriction on the conductivity type of buffer layer 40 and n-type or the like is preferable. There is not any specific restriction on the film thickness of buffer layer 40, where 1nm to 2µm is preferable and 15 to 200 nm is more preferable.

Hereinafter, a method of manufacturing a buffer layer 40 of a Zn compound (which may includes an unavoidable impurity) consisting primarily of Zn(S, O) and/or Zn(S, O, OH) will be described. The present inventors have found that, in a film forming process for forming a Zn compound layer consisting primarily of Zn(S, O) and/or Zn(S, O, OH) by a liquid phase method, a compact buffer layer having carbonyl ions on a surface thereof and well covering an underlayer may be formed at a practical reaction speed by optimizing the composition and pH of the reaction solution and reaction temperature as described above without essentially requiring a fine particle layer that functions as a nucleus or catalyst for crystal growth.

### <Fine Particle Layer Forming Process>

As described above, a fine particle layer forming process for forming a fine particle layer that functions as a nucleus or catalyst for crystal growth is not indispensable in the present embodiment. But the present embodiment may include a fine particle layer forming process prior to the film forming process. In the case where the buffer layer manufacturing method of the present invention includes a fine particle layer forming process, the reaction speed in the film forming process may further be increased.

There is not any restriction on the composition of the fine particle layer but a semiconductor is preferable. As the layer to be formed in the subsequent process is a Zn system, a fine particle layer formed of a plurality of fine particles of one kind or two or more kinds consisting primarily of at least one kind selected from the group consisting of ZnS, Zn(S, 0), and Zn(S, O, OH) is particularly preferable.

There is not any specific restriction on the method of forming the fine particle layer, and a method of applying a dispersion liquid that includes a plurality of fine particles or a method of depositing a plurality of fine particles by CBD (Chemical Bath Deposition) is preferably used.

### <Film Forming Process>

There is not any specific restriction on the film forming method of a Zn compound layer consisting primarily of Zn (S, O) and/or Zn(S, 0, OH) by a liquid phase method, and the CBD method or the like is preferably used. The "CBD method" as used herein refers to a method of depositing a crystal on a substrate at a moderate speed in a stable environment using, as the reaction solution, a metal ion solution having a concentration and a pH that induce supersaturation by the equilibrium represented by a general formula, [M(L)ᵢ]^{m+} ⇔ Mⁿ⁺+iL (where, M is a metal element, L is a ligand, and m, n, and i are positive numbers) and forming complexes of metal ion M.

Hereinafter, preferable compositions of the reaction solution will be described. There is not any specific restriction on a component (Z) and it is preferable that the component (Z) includes at least one kind selected from the group consisting of zinc sulfate, zinc acetate, zinc nitrate, and hydrates of these compounds. There is not any specific restriction on the concentration of the component (Z) and is preferable to be in the range from 0.001 to 0.5M.

There is not any specific restriction on a component (S) and is preferable to include thiourea. There is not any specific restriction on the concentration of the component (S) and is preferable to be in the range from 0.01 to 1.0M.

The component (C) is a component that functions as a complex forming agent and the like, and complexes are formed easily by optimizing the kind and concentration of the component (C). Each of Patent Documents 1 to 7 and Non-Patent Document 2 cited under "Background Art" and "Disclosure of Invention" do not use any citric acid compound. Non-Patent Document 1 uses sodium citrate but the layer formed by the CBD method is a ZnS layer, not a Zn compound layer consisting primarily of Zn(S, O) and/or Zn(S, O, OH).

Use of the component (C), which is at least one kind of citric acid compound, complexes are formed more easily than in the case where reaction solutions that do not use citric acid compounds described in Patent Documents 1 to 7 and Non-Patent Document 3 are used without using an excessive amount of ammonia, and a crystal growth by CBD reaction is controlled favorably so that a film well covering the underlayer may be formed stably.

There is not any specific restriction on the component (C) and is preferable to include trisodium citrate and/or its hydrate. The concentration of the sodium citrate in the reaction solution described in Non-Patent Document 1 is 0. 3M. In the present invention, the concentration of the component (C) is set to a value in the range from 0.001 to 0.25M. A concentration of the component (C) in the range described above allows complexes to be formed favorably so that a film well covering the underlayer may be formed stably. A concentration of the component (C) exceeding 0.25M allows a stable water solution to be prepared with complexes being formed favorably but, on the other side of the coin, the progress of the deposition reaction on the substrate may be slowed or sometimes the reaction does not progress at all. Preferably, the concentration of the component (C) is in the range from 0.001 to 0.1M.

A component (N) is a component that also functions as a pH conditioning agent and the like. There is not any specific restriction on ammonium salts favorably used as a component (N), and NH₄OH and the like may be cited by way of example. The ammonium concentration described in Non-Patent Document 1 is in the range from 0.05 to 0.25M, and it is described that the optimum condition is 0.15M. In the present invention, the concentration of the component (N) is set to a value in the range from 0.001 to 0.40M. By conditioning the pH with the component (N), the degrees of solubility and supersaturation of metal ions may be controlled. A concentration of the component (N) in the range from 0.001 to 0.40M allows the reaction to be fast and film forming to be performed at a practical production speed without the fine particle layer forming process prior to the film forming process. A concentration of the component (N) exceeding 0.40M causes the reaction to be slowed and a certain scheme is required, such as providing a fine particle layer prior to the film forming process. Preferably, the concentration of the component (N) is in the range from 0.01 to 0.30M.

The pH of the reaction solution prior to the start of the reaction is set to a value in the range from 9.0 to 12.0. In the case where the pH of the reaction solution prior to the reaction is less than 9.0, the decomposition reaction of the component (S), such as the thiourea or the like, does not progress at all or may progress but very slowly, so that the deposition reaction does not progress. The decomposition reaction of thiourea takes place in the following manner. The decomposition reaction of thiourea is described, for example, J.M. Dõna and J. Herrero, "Process and Film Characterization of Chemical-Bath-Deposited ZnS Thin Films", Journal of The Electrochemical Society, Vol. 141, Issue 1, pp. 205-210, 1994, and F. Göde et al., "Investigations on the physical properties of the polycrystalline ZnS thin films deposited by the chemical bath deposition method", Journal of Crystal Growth, Vol. 299, Issue 1, pp. 136-141, 2007.

SC(NH₂)₂ + OH⁻ ⇔ SH⁻ + CH₂N₂+H₂O

SH⁻ + OH⁻ ⇔ S²⁻ + H₂O

A pH of the reaction solution exceeding 12.0 prior to the start of the reaction causes the effect of the component (N), which also functions as a complex forming agent and the like, to make a stable solution to be increased so that the deposition reaction does not progress at all or may progress but very slowly. Preferably, the pH of the reaction solution prior to the start of the reaction is in the range from 9.5 to 11.5.

In the reaction solution used in the present invention, the concentration of the component (N) is set to a value in the range from 0.001 to 0.40M and such value of the concentration generally causes the pH of the reaction solution to fall within the range from 9.0 to 12. 0 without requiring any particular pH conditioning, such as the use of a pH conditioning agent other than the component (N).

There is not any specific restriction on the pH of the solution after the reaction. Preferably, the pH of the solution after the reaction is in the range from 7.5 to 11.0. A pH of the solution less than 7.5 after the reaction implies that there has been a time period in which the reaction did not progress and senseless in view of efficient manufacturing. Further, such high pH drop in a system that includes ammonium having a buffering function implies that it is highly likely that the ammonium was excessively evaporated in the heating process and some improvement may be required in the manufacturing process. A pH of the reaction solution exceeding 11.0 after the reaction may have caused the decomposition of the thiourea to be facilitated but the deposition reaction to be significantly slowed because most of the zinc ions are stabilized as ammonium complexes. More preferably, the pH of the reaction solution after the reaction is in the range from 9.5 to 10.5.

In the reaction solution used in the present invention, the pH of the reaction solution after the reaction generally falls within the range from 7.5 to 11.0 without requiring any particular pH conditioning, such as the use of a pH conditioning agent other than the component (N).

The reaction temperature is set to a value in the range from 70 to 95°C. A reaction temperature less than 70°C causes the reaction to be slowed and a thin film does not grow at all or may grow but it is difficult to obtain a desired thickness (e.g., 50nm or more) at a practical reaction speed. A reaction temperature exceeding 95°C causes more bubbles and the like to be generated in the reaction solution which may adhere to the film surface, thereby causing difficulties in growing a flat and homogeneous film. In the case where the reaction takes place in an open system, a reaction temperature exceeding 95°C causes a concentration change due to evaporation of the solvent and the like, thereby causing difficulties in maintaining a stable condition for the thin film deposition. Preferably, the reaction temperature is in the range from 80 to 90°C. There is not any specific restriction on the reaction time. In the present invention, the reaction may take place at a practical reaction speed without a fine particle layer. The reaction time may dependent on the reaction temperature, but a layer well covering the underlayer and having a sufficient thickness as the buffer layer may be formed by a reaction time, for example, in the range from 10 to 60 minutes.

The reaction solution used in the present invention is an aqueous solution and the pH of the solution is not a highly acidic condition. Although the pH of the reaction solution may be 11.0 to 12.0, the reaction may take place under a moderate pH condition of less than 11.0. This allows the use of substrates that include a metal which is easily soluble in an alkaline solvent, such as a metal capable of forming a complex ion with a hydroxide ion, and a high density and uniform buffer layer may be formed without any possibility of damaging the substrates. Such substrates may include, for example, anodized substrates which can be used as flexible substrates, such as an anodized substrate formed of an Al-based Al base with an Al₂O₃-based anodized film formed on at least one surface side, an anodized substrate formed of a composite base of a Fe-based Fe material and an Al-based Al material attached to at least one surface side of the Fe material with an Al₂O₃-based anodized film formed on at least one surface side of the composite base, and an anodized substrate formed of a base of a Fe-based Fe material and an Al-based Al film formed on at least one surface side of the Fe material with an Al₂O₃-based anodized film formed on at least one surface side of the base, and the like.

Further, a high reaction temperature is not essential. Thus, the reaction of the present invention has less environmental burden, and the damage to the substrate is reduced to a minimum.

Further, after the film forming process, by annealing at least the buffer layer at a temperature lower than the upper limit temperature of the substrate, the conversion efficiency may be improved (Examples to be described later). The temperature of the annealing needs to be lower than the upper limit temperature of the substrate and the annealing is effective when the temperature is 150°C or higher. There is not any restriction on the annealing method and heating by a heater, heating in a drying machine, or optical annealing, such as laser annealing or flash lamp annealing, may be employed.

### (Window Layer)

The window layer 50 is an intermediate layer for introducing light. There is not any specific restriction on the composition of the window layer 50 and i-ZnO or the like is preferable. There is not any specific restriction on the film thickness of the window layer 50, in which 10nm to 2µm is preferable and 15 to 200nm is more preferable. The window layer 50 is not essential and some of the photoelectric conversion devices do not have the window layer 50.

### (Transparent Conductive Layer)

The transparent conductive layer (transparent electrode) 60 is a layer that functions as an electrode through which a current generated in photoelectric conversion layer 30 flows with the lower electrode 20 as a pair, as well as introducing light. There is not any specific restriction on the composition of the transparent conductive layer 60, and n-ZnO, such as ZnO:Al or the like, is preferable. There is not any specific restriction on the film thickness of the transparent conductive layer 60, and 50nm to 2µm is preferable.

There is not any specific restriction on the film forming method of the transparent conductive layer 60 and any gas phase method, such as sputtering and the like, or any liquid phase method may be used for forming the transparent conductive layer 60.

### (Upper Electrode)

There is not any specific restriction on the major component of the upper electrode (grid electrode) 70, and Al or the like is preferably used. There is not any specific restriction on the film thickness of the upper electrode 70, and 0.1 to 3µm is preferable.

The photoelectric conversion device 1 of the present embodiment is structured in the manner as described above. The photoelectric conversion device 1 can be favorably used for solar cell applications and the like. It can be turned into a solar cell by attaching, as required, a cover glass, a protection film, and the like. The photoelectric conversion device 1 has a buffer layer 40 that includes a ternary compound of a cadmium-free metal, oxygen, and sulfur, and has carbonyl ions on a surface facing the transparent conductive layer 50. According to such structure, the compactness of the buffer layer is increased by the presence of the carbonyl ions. Thus, the photoelectric conversion device 1 according to the present embodiment may be a photoelectric conversion device that includes a buffer layer 40 uniformly covering a photoelectric conversion semiconductor layer 30, the underlayer thereof, and has high in-plane homogeneity of photoelectric conversion efficiency.

The buffer layer 40 described above may be formed under moderate alkaline conditions. This allows the use of a base material which includes a metal easily soluble in an alkaline solvent, such as aluminum, as the substrate 10. Therefore, an embodiment having a substrate 10 that includes a thin and highly flexible aluminum metal may provide a flexible photoelectric conversion device 1 having high in-plane homogeneity of photoelectric conversion efficiency.

### [Design Changes]

The present invention is not limited to the embodiment described above, and design changes may be made as appropriate without departing from the sprit of the invention.

### [Examples]

Examples and comparative examples of the present invention will now be described.

### [Evaluation of Buffer Layers]

### <Substrates>

As for substrates, Substrate 1 and Substrate 2 described below were provided.

Substrate 1: a substrate that uses an anodized substrate made of a composite base of a 100µm thick stainless steel (SUS) and a 30µm thick Al with an anodized aluminum film (AAO) formed on the surface of the Al, and a soda lime glass (SLG) layer, a Mo electrode layer, and a CIGS layer are further formed on the surface of the AAO on top of each other. The SLG layer and Mo lower electrode were formed by sputtering and a Cu(In_{0.7}Ga_{0.3})Se₂ layer was formed by three-stage process. The film thickness of each layer was as follows: SUS (greater than 300µm); Al (300µm); AAO (20µm); SLG (0.2µm); Mo (0.8µm); and CIGS (1.8µm).

Substrate 2: a substrate having a soda lime glass (SLG) substrate with a Mo electrode layer on which a CIGS layer is formed. More specifically, a Mo lower electrode was formed on a 30mm×30mm soda lime glass (SLG) substrate with a thickness of 0.8µm by sputtering. Then, a Cu(In_{0.7}Ga_{0.3})Se₂ layer was formed on the substrate with a thickness of 1.8µm by three-stage process known as one of the film forming methods of CIGS layers.

### (Example 1)

First, a reaction vessel containing a 10% KCN aqueous solution was provided and the surface of the CIGS layer formed on the substrate was immersed in the vessel for three minutes at room temperature in order to remove impurities on the surface of the CIGS layer. After being taken out from the vessel, the substrate was sufficiently washed with water and subjected to a CBD process to be described later.

An aqueous solution of zinc sulfate (0.18[M]) as an aqueous solution (I) of the component (Z), an aqueous solution of chiourea (0.30[M]) as an aqueous solution (II) of the component (S), an aqueous solution of trisodium citrate as an aqueous solution (III) of the component (C), and aqueous ammonia (0.3[M]) as an aqueous solution (IV) of the component (N) were prepared respectively. Then, the solutions I, II, III were mixed in equal amounts to provide a mixed aqueous solution of 0.06[M] zinc sulfate, 0.10[M] chiourea, and 0.06[M] trisodium citrate. Then the mixed aqueous solution so provided and the 0. 30 [M] aqueous ammonia were mixed in equal amounts to obtain a reaction solution. When mixing the aqueous solutions (I) to (IV), the aqueous solution (IV) was added last. It is important to add the aqueous solution (IV) last in order to obtain a transparent reaction solution. The pH of the obtained reaction solution 1 was 10.3.

Next, using the reaction solution 1, a Zn(S, O)-based and/or Zn(S, O, OH)-based buffer layer was formed on the substrate 1 by CBDmethod (Sample 1). More specifically, the buffer layer was formed by immersing the substrate 1, on which a CIGS layer was formed, in 500ml of the reaction solution controlled at a temperature of 90°C for one hour, taking out the substrate 1 from the reaction solution and sufficiently washing the substrate with pure water, and drying the substrate at room temperature. In the process of immersing the substrate in the reaction solution, the substrate was placed such that the surface of the substrate is perpendicular to the bottom surface of the reaction solution container.

### (Example 2)

Sample 2 was produced in a manner identical to that of Example 1 except that the substrate was annealed at 200°C for one our after a buffer layer was formed.

### (Example 3)

Sample 3 was produced in a manner identical to that of Example 2 except that Substrate 2 was used as the substrate.

### (Comparative Example 1)

An aqueous solution of 0.077M zinc chloride, 0.71M thiourea, 1.39M ammonia, and 2.29M hydrazine was prepared, and a hydrochloric acid aqueous solution was added to provide a reaction solution with a pH of 10.3. Then Sample 4 was produced by introducing the substrate 1 into the reaction solution and causing a reaction for one hour at 90°C.

### <Evaluation 1 (Evaluation of Buffer Layer Surface)>

A buffer layer surface evaluation was performed with respect to each Example and Comparative Example 1. As for the buffer layer surface evaluation, surface condition observations by SEM and surface substance identifications by infrared spectroscopic analysis (IR) were performed.

In order to analyze the covering state of the buffer layer over the CIGS layer, FIB processing was performed after a protection layer was formed on each buffer layer surface to perform SEM observations. This evaluation also showed that the buffer layers are favorably covering the CIGS layers respectively.

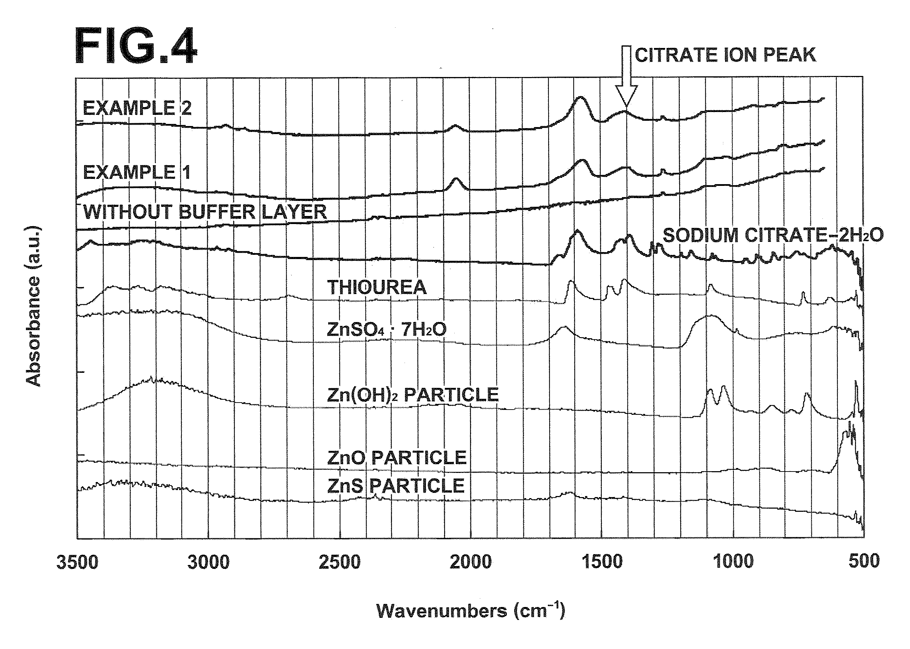

Then, IR spectral measurements were performed on the buffer surfaces of each Example and Comparative Example 1 to identify surface substances. For the measurements, an infrared spectrometer, MFT-2000 available from JASO Corporation was used. The results are shown in Figure 4.

Figure 4 shows IR spectra of Sample 1 of Example 1, Sample 2 of Example 2, and a CIGS film surface before a buffer layer was formed measured by ATR method. Figure 4 further shows IR spectra of raw powder of trisodium citrate dehydrate (produced by Wako Pure Chemical Industries, Ltd.), raw powder of thiourea (produced by Wako Pure Chemical Industries, Ltd.), zinc sulfate heptahydrate (produced by Kanto Chemical Industry Co., Ltd.), Zn (OH)₂ particle (synthetic), ZnO particle (produced by Japan Pure Chemical Co., Ltd.), and ZnS particle (produced by Kanto Chemical Industry Co., Ltd.) measured by KBR disk method. As shown in the graph, while a citric acid peak was detected (position indicated by the arrow in the graph) from each of Samples 1 and 2, a trisodium citrate peak was not detected from the sample without a buffer layer.

Although, a thiourea peak is also present at the position indicated by the arrow in the graph, it is thought that the thiourea is a highly water-soluble compound and it is dissolved in water and washed away during a washing process in the water-based film forming as in the present embodiment. Thus, it was confirmed from Figure 4 that citric acid ions are present on the surface of the buffer layer.

A citric acid peak was also detected from Example 3 while a citric acid peak was not detected from Comparative Example 1.

### <Evaluation 2 (Evaluation of Buffer Layer Composition)>

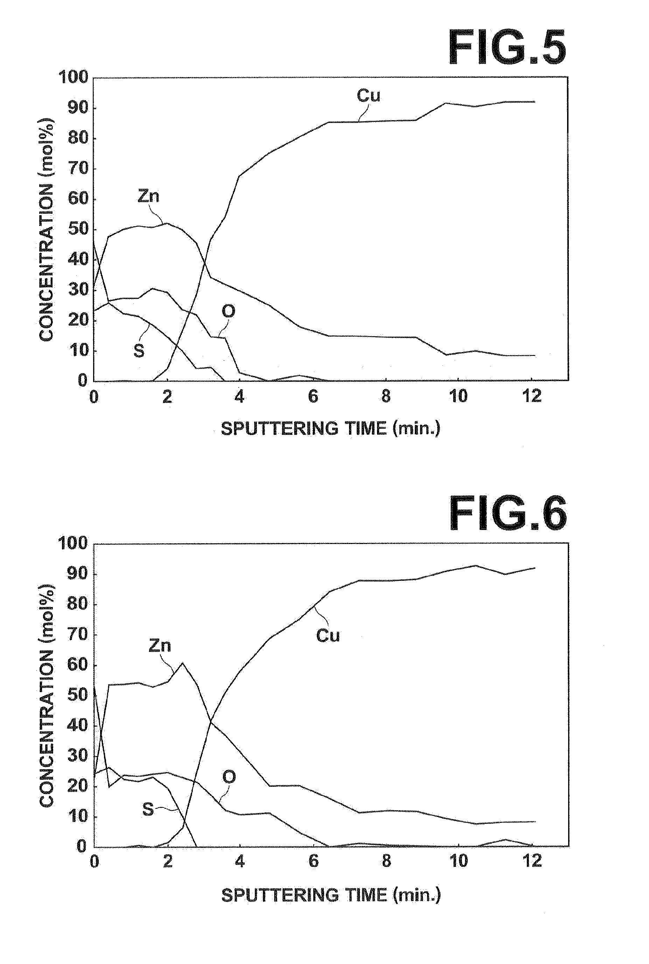

Buffer layers were formed on the respective CIGS substrates cut into 1cm squares in advance under conditions identical to those of Example 1 to Example 3 and of Comparative Example 1 and composition analysis was conducted for the obtained samples. For the measurements, a composition analysis of each sample was conducted in the depth direction by X-ray photoelectron spectroscopy (XPS) after the buffer layer was formed. Results of Examples 1 and 2 are shown in Figures 5 and 6 respectively.

The XPS measurement that involves etching was performed under the following conditions. In Figures 5 and 6, the horizontal axis represents the sputtering time (min.) and the sputtering time corresponds to the etch depth. The conversion from the sputtering time to etch depth can be made with reference to the etching rate calculated using a SiO₂ film (with Si wafer substrate) having a known film thickness as the standard sample. The conversion of the thickness of the buffer layer was made based on the position where S component in the buffer layer was not detected any more.

### XPS Analysis

Device Used: X-ray photoelectron spectroscopy, Quantum - 2000 - 2000(available from PHI Company)
X-Ray Source: Monochromated-Al-Kα Ray (1486.6eVeV) 20W
Photoelectron Take-Off Angle: 45° (measurement depth at one measuring point: about 4nm) Measurement Area: Φ100µm (elliptical shape)
Ar Ion Sputtering Conditions:
   Accelerating Voltage: 4kV
   Sputtering Rate: 19.0nm/min (SiO₂ equivalent)

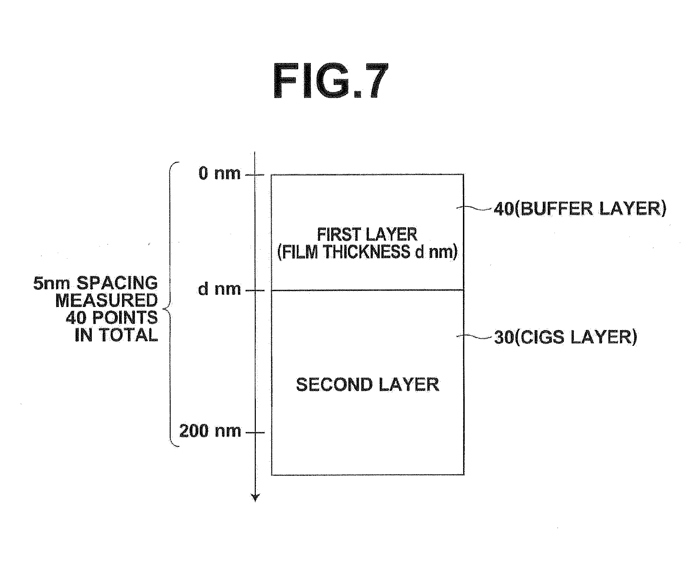

From the results shown in Figures 5 and 6, a thickness d of the buffer layer, and a ratio between S and 0 components and the distribution thereof were measured when each sample was embodied like that of schematic diagram shown in Figure 7. The measurement results showed that both S and O are present in the buffer layer. It was also confirmed that the thickness calculated based on the time when S was not detected any longer is 68nm for Example 1 and 53nm for Example 2.

It was also confirmed that Zn is present at the position where S was not detected any longer. This is thought to be due to the diffusion of Zn²⁺ in the CIGS layer during the CBD process. The comparison of S component ratio in each buffer in terms of S/(S+O) obtained from analysis results of a surface exposed after etched for one to two minutes in the XPS measurement that involves etching showed 0.44 for Example 1, 0.48 for Example 2, 0.48 for Example 3, and 1.0 for Comparative Example 1. That is, the composition of the buffer layer of each of Example 1 to Example 3 is Zn(S, O) or Zn(S, 0, OH). In the mean time, O component was not detected from the buffer layer of Comparative Example 1. That is, the composition of Comparative Example 1 was confirmed to be ZnS.

### <Manufacture of Photoelectric Conversion Device-Continuation>

Al-doped conductive zinc oxide thin film was formed on the buffer layer of each of Examples 1 to 3 and Comparative Example 1 with a thickness of 300nm by sputtering. Then, an Al electrode was formed by vapor deposition as the upper electrode to produce a photoelectric conversion device (single solar cell). Sixteen cells were produced and evaluated with respect to each example and comparative example.

### <Evaluation of Photoelectric Conversion Efficiency>

Evaluation of current-voltage characteristic was made for the obtained four photoelectric conversion devices (each having 16 cells) by measuring energy conversion efficiency using a solar simulator under the condition in which pseudo sunlight of Air Mass (AM) = 1.5, 100mW/cm² was used.

Results obtained are summarized in Table 1 together with major manufacturing conditions of each Example and Comparative Example. In Table 1, the coatability evaluation represents the results of FESEM observations of sample pieces obtained by FIB processing the cross-sections of the samples and counting the number of uncoated areas in a width direction of 100µm in which the circle "○" indicates that the number of uncoated areas is two or less and the triangle "Δ" indicates that the number of uncoated areas is less than ten.

In Table 1, the energy conversion efficiency is indicated by an average value of 16 cells with a standard deviation of the 16 cells. As indicated in Table 1, the effectiveness of the photoelectric conversion device of the present invention has been confirmed.

**[Table 1]**

| | Example 1 | Example 2 | Example 3 | Comparative Example 1 |
|---|---|---|---|---|
| Substrate | Cu(In_{0.7}Ga_{0.3})Se₂/Mo/Substrate 1 | Cu(In_{0.7}Ga_{0.3})Se₂/Mo/Substrate 1 | Cu(In_{0.7}Ga_{0.3})Se₂/Mo/SLG | Cu(In_{0.7}Ga_{0.3})Se₂/Mo/Substrate 1 |
| Buffer Layer Composition | Zn(S,O) | Zn(S,O) | Zn(S,O) | ZnS |
| Annealing after Buffer Layer Formation | Not Performed | 200°C/One Hour | 200°C/One Hour | Not Performed |
| S/(S+O) (Molar Radio) | 0.44 | 0.48 | 0.48 | 1.0 |
| Absorption of Carbonyl Ion | Yes | Yes | Yes | No |
| Crystallisation | Mixed State of Crystalline and Amorphous Portions | Mixed State of Crystalline and Amorphous Portions | Mixed State of Crystalline and Amorphous Portions | - |
| Coatability over CIGS Layer | ○ | ○ | ○ | Δ |
| Energy Conversion Efficiency(%) | 8.90 | 13.24 | 13.85 | 6.30 |
| Standard Deviation of Energy Conversion Efficiency | 1.88 | 1.61 | 1.45 | 3.31 |

The buffer layer of the present invention and the manufacturing method thereof are applicable to photoelectric conversion devices used for solar cells, infrared sensors, and the like.

## Claims

1. A photoelectric conversion device, comprising a substrate on which the following are layered in the order listed below: a lower electrode layer, a photoelectric conversion semiconductor layer which includes, as a major component, at least one kind of compound semiconductor having a chalcopyrite structure formed of a group Ib element, a group IIIb element, and a group VIb element; a buffer layer; and a transparent conductive layer, wherein the buffer layer
includes a ternary compound of a cadmium-free metal, oxygen, and sulfur, and
has a carbonyl ion on a surface facing the transparent conductive layer.

2. The photoelectric conversion device of Claim 1, wherein the carbonyl ion has a plurality of carbonyl groups.

3. The photoelectric conversion device of Claim 1 or 2, wherein the carbonyl ion is a citrate ion.

4. The photoelectric conversion device of any of Claims 1 to 3, wherein the carbonyl ion is adsorbed on the surface.

5. The photoelectric conversion device of any of Claims 1 to 4, wherein the buffer layer includes a crystalline portion and an amorphous portion.

6. The photoelectric conversion device of any of Claims 1 to 5, wherein a molar ratio of sulfur atoms to a total number of moles of the sulfur atoms and oxygen atoms in the buffer layer is in the range from 0.2 to 0.8.

7. The photoelectric conversion device of any of Claims 1 to 6, wherein the cadmium-free metal is at least one kind of metal (which may include an unavoidable impurity) selected from the group consisting of Zn, In, and Sn.

8. The photoelectric conversion device of Claim 7, wherein the cadmium-free metal is Zn.

9. The photoelectric conversion device of any of Claims 1 to 8, wherein the substrate includes a metal capable of forming a complex ion with a hydroxide ion.

10. The photoelectric conversion device of Claim 9, wherein the substrate is an anodized substrate selected from the group consisting of:
an anodized substrate formed of an Al-based Al base with an Al₂O₃-based anodized film formed on at least one surface side;
an anodized substrate formed of a composite base of a Fe-based Fe material and an Al-based Al material attached to at least one surface side of the Fe material with an Al₂O₃-based anodized film formed on at least one surface side of the composite base; and
an anodized substrate formed of a base of a Fe-based Fe material and an Al-based Al film formed on at least one surface side of the Fe material with an Al₂O₃-based anodized film formed on at least one surface side of the base.

11. The photoelectric conversion device of any of Claims 1 to 10, wherein the major component of the photoelectric conversion semiconductor layer is at least one kind of compound semiconductor, comprising:
at least one kind of group Ib element selected from the group consisting of Cu and Ag;
at least one kind of group IIIB element selected from the group consisting of Al, Ga, and In; and
at least one kind of group VIb element selected from the group consisting of S, Se, and Te.

12. A solar cell, comprising the photoelectric conversion device of any of Claims 1 to 11.
